# EUROPEAN PATENT APPLICATION

(11) **EP 4 801 251 A1**
(43) Date of publication of application: **02.09.2026**
(21) Application number: 26155884.5
(22) Date of filing: 03.02.2026
(51) Int. Cl.: H10W 70/40, H10W 40/77, H10W 90/00, H10W 74/10

(54) **PACKAGED DEVICE, METHOD FOR MANUFACTURING, AND LEAD FRAME**

(30) Priority: 27.02.2025 CN 202510227739
(71) Applicant: NXP USA, Inc., Austin, TX 78735 (US)
(72) Inventor: Ge, You, 5656AG Eindhoven (NL); Wang, Zhijie, 5656AG Eindhoven (NL); Lee, Yit Meng, 5656AG Eindhoven (NL); Shah, Ankur Shailesh, 5656AG Eindhoven (NL)
(74) Representative: Colaiuda, Antonella

(57) **Abstract**

A packaged device includes a substrate, a die, a die flag, and a plurality of leads. The substrate has a lower surface and an upper surface opposite the lower surface. The die is arranged on the upper surface of the substrate. The die has a lower surface facing the upper surface of the substrate, and an upper surface opposite the lower surface. The die flag includes a cover portion which is arranged over the upper surface of the die. The cover portion has a lower surface and an upper surface opposite the lower surface. The lower surface of the cover portion faces the upper surface of the die. The plurality of leads is arranged around a periphery of the substrate. The plurality of leads includes a first lead connected to the die flag, and a second lead separated from the die flag. Each of the plurality of leads includes an outer portion which has a lower surface and an upper surface opposite the lower surface. The lower surfaces of the plurality of leads are coplanar with and separated from the lower surface of the substrate.

## Description

### BACKGROUND

The present disclosure relates to a packaged device, a lead frame for the packaged device, and a method for manufacturing the packaged device.

Semiconductor devices are usually packaged in Ball-Grid-Array (BGA) formats, benefiting from high density I/O pins and accordingly small outline sizes. A BGA packaged device includes solder balls that are arranged in an array on a lower surface, for being mounted to a board which carries the BGA packaged device. The solder balls act as electrical connections between the BGA packaged device and the board. Generally, heat produced by the BGA packaged device is also dissipated through the solder balls. However, dissipating heat through the solder balls of the BGA packaged device suffers from low efficiency.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In one embodiment, a packaged device includes a substrate, a die, a die flag, and a plurality of leads. The substrate has a lower surface and an upper surface opposite the lower surface. The die is arranged on the upper surface of the substrate. The die has a lower surface facing the upper surface of the substrate, and an upper surface opposite the lower surface. The die flag includes a cover portion which is arranged over the upper surface of the die. The cover portion has a lower surface and an upper surface opposite the lower surface. The lower surface of the cover portion of the die flag faces the upper surface of the die. The plurality of leads is arranged around a periphery of the substrate. The plurality of leads includes a first lead connected to the die flag, and a second lead separated from the die flag. Each of the plurality of leads includes an outer portion. The outer portion has a lower surface and an upper surface opposite the lower surface. The lower surfaces of the outer portions of the plurality of leads are coplanar with and separated from the lower surface of the substrate.

In another embodiment, there is provided a method for manufacturing a packaged device. The packaged device includes a substrate, a die, and a lead frame. The method includes: mounting the die to the substrate, with a lower surface of the die facing an upper surface of the substrate; arranging a die flag of the lead frame over an upper surface of the die; arranging a plurality of leads of the lead frame to be around a periphery of the substrate. Each of the plurality of leads includes an outer portion which has a lower surface and an upper surface opposite the lower surface. Arranging the plurality of leads such that lower surfaces of the outer portions of the plurality of leads are coplanar with and separated from a lower surface of the substrate. The plurality of leads include a first lead connected to the die flag, and a second lead separated from the die flag.

In yet another embodiment, a lead frame includes a die flag and a plurality of leads. The die flag includes a cover portion which has a lower surface and an upper surface opposite the lower surface. The plurality of leads is arranged around, and spaced apart from, the die flag. Each of the plurality of leads includes an outer portion which has a lower surface and an upper surface opposite the lower surface. The plurality of leads includes a first lead connected to the die flag and a connector bar; and a second lead connected to the connector bar and separated from the die flag.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
Fig. 1 is a cross-sectional view of a packaged device according to an embodiment;
Fig. 2 is a top planar view of a packaged device according to another embodiment, without applying the molding compound;
Fig. 3 is a schematic cross-sectional view, along the A-A line, of the packaged device of Fig. 2;
Fig. 4 is a schematic cross-sectional view, along the B-B line, of the packaged device of Fig. 2;
Fig. 5 is a cross-section of the die flag and the second lead of the packaged device of Fig. 3;
Fig. 6 is a cross-section through the die flag, the first lead, and the tie bar of the packaged device of Fig. 4;
Fig. 7 is a plan view of a lead frame according to an embodiment; and
Fig. 8 shows cross-sectional views of assemblies during a flow of manufacturing a packaged device according to an embodiment.

### DETAILED DESCRIPTION

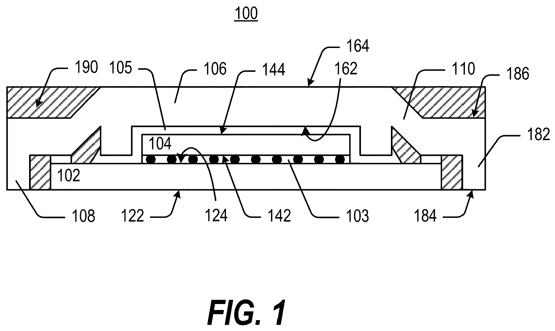

Fig. 1 is a cross-sectional view of a packaged device according to an embodiment. The packaged device 100 includes a substrate 102, a die 104, a die flag 106, and a plurality of leads 108. The substrate 102 has a lower surface 122 and an upper surface 124 opposite the lower surface 122. The die 104 is arranged on the upper surface 124 of the substrate 102. The die 104 has a lower surface 142 facing the upper surface 124 of the substrate 102. The die 104 further has an upper surface 144 opposite the lower surface 142. The die 104 may be disposed such that active layers of the die 104 that are used for forming semiconductor devices and produce major heat are near the upper surface 144, and the heat may be dissipated by way of the thermal interface material 105, which will be described in more detail hereinbelow. In other examples, the die 104 may be disposed such that its active layers are near the lower surface 142, and the heat may be dissipated by way of the substrate 102. The die 104 may be a semiconductor device die which is fabricated through known semiconductor processes, and has a mass heat generation capacity which requires efficient heat dissipation.

The die flag 106 is arranged over the upper surface 144 of the die 104. As can be seen from Fig. 1, the die flag 106 includes a cover portion arranged in a central position, and a flange portion adjoining the cover portion at peripheral sides of the cover portion. Details of the die flag according to the embodiments will be described hereinbelow. The cover portion of the die flag 106 has a lower surface 162 which faces the upper surface 144 of the die 104, and is spaced apart therefrom by the thermal interface material 105, as will be described in more detail hereinbelow. The cover portion of the die flag 106 also has an upper surface 164 which is opposite the lower surface 162. The plurality of leads 108 are arranged surrounding, or around a periphery of, the substrate 102. The plurality of leads 108 include a first lead 182 which is connected to the die flag 106 by way of a link section of a lead frame for manufacturing the packaged device 100, which may also be referred to as a tie bar 110. That is to say, the first lead 182, the tie bar 110, and the die flag 106 are continuously adjoined. Fig. 1 shows two first leads 182 arranged on both sides of the packaged device 100. As described above, Fig. 1 is a cross-sectional view of the packaged device 100, it will be seen from the drawings hereinafter, the plurality of leads 108 are arranged along the side faces of the packaged device 100. In addition, the plurality of leads 108 include a second lead (not shown in Fig. 1) which is not connected to the die flag 106. That is to say, the second lead is separated from the die flag 106. As shown in Fig. 1, each of the plurality of leads 108 includes an inner portion which is directly connected to the tie bar 110, and an outer portion which is connected to the inner portion and exposed on side faces of the packaged device 100. Details of the leads according to the embodiments will be described hereinbelow. The outer portion of each of the plurality of leads 108 has a lower surface 184, and an upper surface 186 opposite the lower surface 184. The lower surface 184 of the outer portion of the lead 108 is coplanar with and separated from the lower surface 122 of the substrate 102.

According to an embodiment, the die 104 is mounted onto the substrate 102 through a flip-chip technology. The die 104 is fabricated such that multiple connection pads (not labelled) are arranged on its surface, usually on an initially upper-facing surface such that the connection pads are easily inspected and tested. In the packaged device 100, the die 104 is "flipped" and placed on the substrate 102 with the connection pads being at the bottom and facing the upper surface 124 of the substrate 102 on which corresponding soldering materials are already disposed. The soldering materials disposed on the upper surface 124 of the substrate 102 may be soldering paste printed onto the upper surface 124, or solder balls planted on the upper surface 124. The die 104 is loaded onto the substrate 102, with the connection pads aligned with corresponding solder paste/solder balls. An assembly of the die 104 and the substrate 102 is heated according to a reflow process such that the solder paste/solder balls melt and cure, to create reliable mechanical and electrical connections between the die 104 and the substrate 102. In some embodiments, the packaged device 100 further includes underfill 103 which fills in the gap between the die 104 and the substrate 102.

The packaged device 100 further includes thermal interface material 105 disposed between the die 104 and the die flag 106. The thermal interface material 105 may be thermally conductive silicone grease, which facilitates the heat generated by the die 104 to be dissipated through the die flag 106, the tie bar 110, and the connected first lead 182. The packaged device 100 further includes molding materials 190 which encapsulates the substrate 102, the die 104, the die flag 106, and parts of the leads 108. The molding material 190 leaves exposed the upper surface 164 of the cover portion of the die flag 106, part of the lead 108, and the lower surface 122 of the substrate 102. The exposed upper surface 164 of the cover portion of the die flag 106 and the exposed part of the first lead 182 further facilitate the heat generated by the die 104 to be dissipated. The exposed lower surface 122 of the substrate 102 allows further connection balls to be arranged thereon, such that the packaged device 100 is a Ball Grid Array (BGA) packaged device. Alternatively, the exposed lower surface 122 of the substrate 102 may have connection pads arranged thereon such that the packaged device 100 is a Land Grid Array (LGA) packaged device.

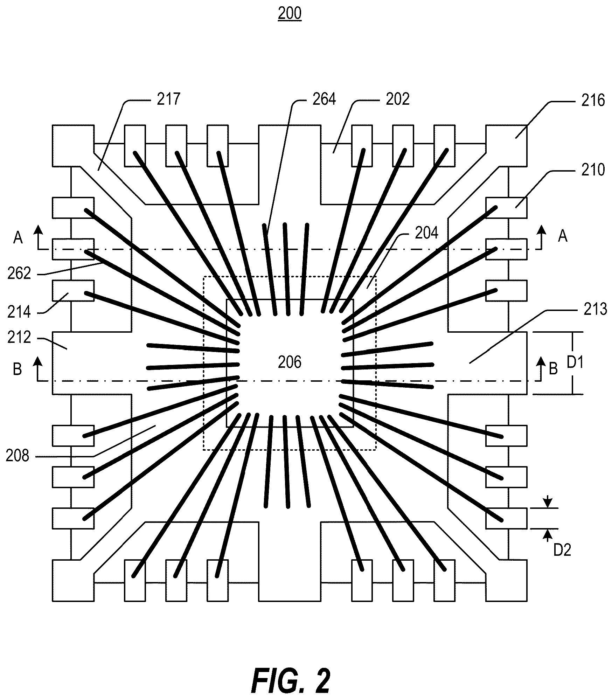

Fig. 2 is a top planar view of a packaged device 200 according to another embodiment, without applying the molding compound. The packaged device 200 is a multi-die device, and includes substrate 202 on which a first die 204 and a second die 206 are stacked. The first die 204 is similar to the die 104 of Fig. 1, and is mounted to the substrate 202 through the flip-chip technology. The first die 204 according to this embodiment is typically a device die which, in operation, generates a relatively low amount of heat, while the second die 206 according to the embodiment typically generates a relatively large amount of heat.

The packaged device 200 includes a die flag 208 and a plurality of leads 210. The die flag 208 is arranged between the first die 204 and the second die 206, and extends beyond the perimeter of both the first die 204 and the second die 206. The plurality of leads 210 includes a first lead 212, a second lead 214, and a third lead 216. The first lead 212 is similar to the first lead 182 of Fig. 1, and is connected to the die flag 208 by way of a link section of the lead frame, which may also be referred to as a tie bar 213. The second lead 214 is spaced apart and electrically separated from the die flag 208. The second lead 214 is electrically connected to the second die 206, for example through bond wires 262. The bond wires 262 typically, in use, carry signals between the second die 206 and the second lead 214. Herein, the term "signal" is to be interpreted broadly so as to include both power and data, which may be either digital or analog, and carrier signals. In some embodiments, the first lead 212 is also electrically connected to the second die 206, for example through the connected tie bar 213, the die flag 208, and bond wires 264. The first lead 212 is connectable to ground voltage levels, and the bond wires 264 accordingly couple a ground voltage level into the second die 206. Alternatively, the first lead 212 is connected to conduct other applicable signals or voltages.

The first leads 212 and the second leads 214 are arranged along the side faces of the packaged device 200, and the third leads 216 are arranged at corners, between the side faces, of the packaged device 200. Similar to the first lead 212, the third lead 216 is connected to the die flag 208 through a corresponding link section or tie bar 217. That is to say, the third lead 216, the tie bar 217, and the die flag 208 are continuously adjoined. The tie bar 217 extends between the third lead 216 and the die flag 208. Measured along the side face, a first width D1 of the first lead 212 is larger than a second width D2 of the second lead 214. In the embodiment, the first width D1 may be in a range between 0.2mm and 1.0mm, and the second width D2 may be in a range between 0.2mm and 0.3mm. As will be described, the first lead 212 is connected to the die flag 208 which is underneath the second die 206, and so heat generated by the second die 206 will be dissipated through the die flag 208 and the connected first lead 212. Having a relatively large width and accordingly a large area, the first lead 212 has a high heat dissipation efficiency. As described above, the first lead 212 and the third lead 216 are connectable to couple ground voltage levels or various types of signals, and the large area is beneficial in carrying large currents.

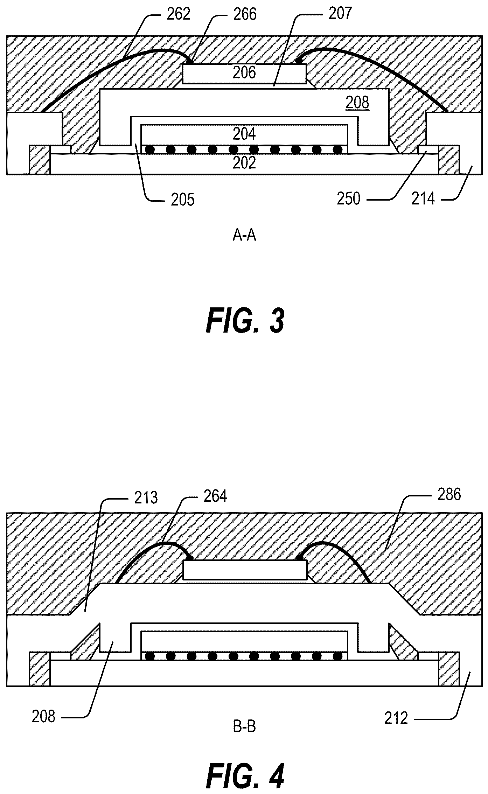

Fig. 3 is a schematic cross-sectional view, along the A-A line, of the packaged device 200 of Fig. 2. Although not visible in the figure, the encapsulant or molding compound 286 is partially cut-away, so as to show various components such as the first die 204 and the second die 206. The A-A cross-sectional line crosses along the second lead 214. Similar to the embodiment of Fig. 1, the first die 204 is arranged on the upper surface of the substrate 202 of the packaged device 200, for example through the flip-chip technology. The substrate 202 may be a laminated board with re-distribution layers (not shown), such that when the first die 204 is attached to the substrate 202, signals can be guided between the first die 204 and pads/balls (not shown) on the lower surface of the substrate 202 through the re-distribution layers. In the embodiment, the substrate 202 may have a thickness of about 0.1mm (for example, in a range, between 0.08mm and 0.12mm). The die flag 208 is positioned over, and spaced apart from, the first die 204, and covers the first die 204. Thermal Interface Material (TIM) 205 is filled between the first die 204 and the die flag 208. As shown in Fig. 3 and will be described in detail hereinbelow, the die flag 208 has a recess in the central portion which accommodates the first die 204 therein, such that the die flag 208 is a cover which is positioned over the first die 204. As will be described, the second die 206 is further positioned over the die flag 208. In operation, the TIM 205 may assist in propagating heat produced by either or both of the first die 204 and the second die 206 to the die flag 208. The second die 206 is attached to the upper surface of cover portion of the die flag 208 through an adhesive material 207, for example epoxy. The epoxy may have a relatively high (compared with encapsulant) thermal conductivity. The epoxy may be electrically conductive, or electrically nonconductive. On the upper surface of the second die 206, multiple connection pads 266 are arranged. In Fig. 3, the size of the connection pads 266 are enlarged for easy illustration. The connection pads 266 are generally each connected to a corresponding second lead 214 through the bond wire 262. As shown in Fig. 3, the lower surface of the outer portion of the second lead 214 is coplanar with and separated from the lower surface of the substrate 202, such that both the lower surface of outer portion of the second lead 214, and the lower surface of the substrate 202, form part of a lower surface of the packaged device 200.

Fig. 4 is a schematic cross-sectional view, along the B-B line, of the packaged device 200 of Fig. 2. The B-B cross-sectional line crosses along the first lead 212 and the connected tie bar 213. It can be understood that the cross-sectional view along a line through the third lead 216 and the connected tie bar 217 is also similar to Fig. 4, but with different sizes, and no bond wire 264. As shown in Fig. 4, the first lead 212 is connected to the die flag 208 through the tie bar 213. Bond wires 264 are used for electrically connecting the connection pad on the second die 206 with the die flag 208, and accordingly by way of the tie bar 213 with the first lead 212 which is connectable to a ground voltage level or other required signal paths. The packaged device 200 further includes the molding compound 286 which encapsulates the substrate 202, the first die 204, the second die 206, the die flag 208, and the plurality of leads 210, etc. Molding compound 286 is partially cut-away in Fig. 4 (not shown) to make visible the entirety of the bond wire 264. The molding compound 286 leaves exposed the lower surface of the substrate 202, and the lower surfaces of the outer portions of the plurality of leads 210 that are coplanar with the lower surface of the substrate 202.

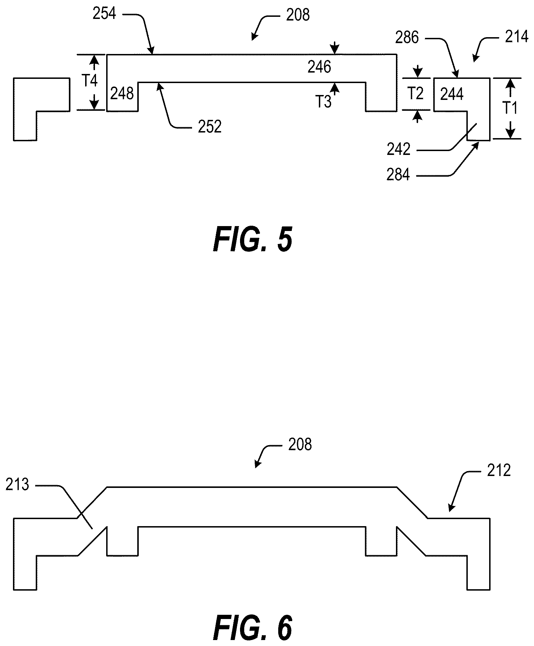

The die flag 204 and the plurality of leads 210 may be provided from a lead frame in manufacturing the packaged device of Fig. 2. Fig. 5 is a cross-section of the die flag 208 and the second lead 214 of the packaged device 200 of Fig. 3. The second lead 214 includes an outer portion 242 and an inner portion 244. The inner portion 244 is connected to the outer portion 242, and extends from the outer portion 242 towards the die flag 208. Measured from a lower surface 284 to an upper surface 286 of the outer portion 242, the outer portion 242 has a first thickness T1. Along the same direction, the inner portion 244 has a second thickness T2 which is less than the first thickness T1. In the embodiment, the first thickness T1 is in a range between 0.15mm and 0.25mm, and is typically about 0.2mm, and the second thickness T2 is in a range between 0.08mm and 0.12mm, and is typically about 0.09-0.1mm. Referring back to Fig. 3, the inner portion 244 of the second lead 214 is arranged to extend over a perimeter part of the substrate 202. In the embodiment, the second lead 214 is arranged onto the upper surface of the substrate 202 through solder 250, such that the first thickness T1 of the outer portion 242 of the second lead 214 equals a sum of the second thickness T2 of the inner portion 244, the thickness of the substrate 202, and a thickness of the solder 250.

The die flag 208 includes a cover portion 246 and a flange portion 248. The cover portion 246 is arranged generally centrally within the die flag 208. The flange portion 248 is connected to the cover portion 246 and extends outwards from the cover portion 246. Measured from a lower surface 252 to an upper surface 254 of the cover portion 246, the cover portion 246 has a third thickness T3. Along the same direction, the flange portion 248 has a fourth thickness T4 which is larger than the third thickness T3. In the embodiment, the third thickness T3 generally equals the second thickness T2, which may be about 0.1mm; and the fourth thickness T4 generally equals the first thickness T1, which may be about 0.2mm. Referring back to Fig. 3, the cover portion 246 is arranged over, spaced apart from, and aligned with the first die 204, and the flange portion 248 extends around the side faces of the first die 204, such that the die flag 208 is a cap which covers the first die 204, and the first die 204 is recessed within the die flag 208.

Fig. 6 is a cross-section through the die flag 208, the first lead 212, and the tie bar 213 of the packaged device 200 of Fig. 4. The first lead 212 is similar to the second lead 214 of Fig. 5, and will not be described in details. The tie bar 213 connects the first lead 212 with the die flag 208. That is to say, the tie bar 213 extends between the die flag 208 and the first lead 212. In the embodiment, the tie bar 213 has a thickness which is equal to the thickness of the second portion of the first lead 212, which may be 0.1mm. The third lead 216 and its connected tie bar 217 of Fig. 2 may have similar configurations to the first lead 212 and the tie bar 213.

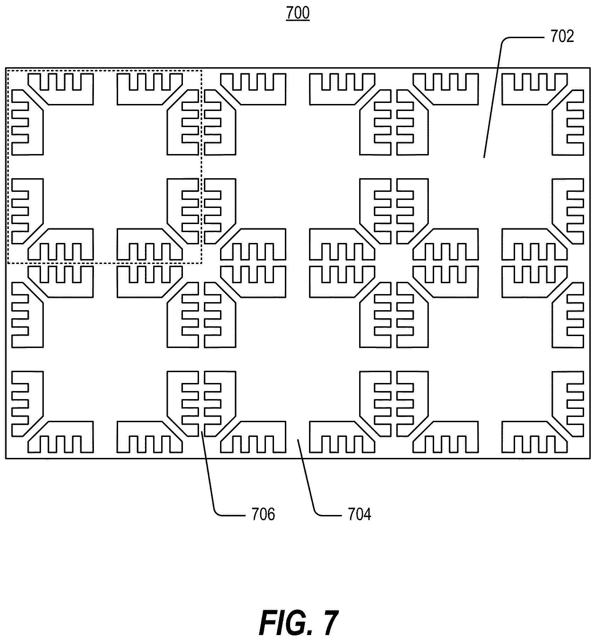

As described, the die flag 208 and the plurality of leads 210 are provided into the packaged device 200 from a lead frame. Fig. 7 is a plan view of a lead frame according to an embodiment, prior to any forming of the lead frame: in other words, in the condition that the top surface of the lead frame is planar. The lead frame 700 includes multiple die flags 702 that are arranged in an array. Each die flag 702 is surrounded by a corresponding plurality of leads 704 including the first lead, the second lead, and the third lead. The leads 704 are arranged along peripheral sides of the die flag 702 and spaced apart from the die flag 702. In the lead frame 700, one of the plurality of leads 704 arranged for one die flag 702 is connected to a neighboring lead 704 arranged for another neighboring die flag 702, through a connector bar 706. The connector bar 706 will be removed during a singulation process in manufacturing the packaged device, which will be described in further details hereinafter.

The lead frame 700 outline may be provided from stamping or etching a metal sheet to form the die flag 702 and the plurality of leads 704. The metal sheet is typically made from a metal such as copper. The die flag 702, the plurality of leads 704 and the tie bars connecting the die flag 702 with the second lead and the third lead are partially etched such that the die flag 702 has a thinned portion as the cover portion as described with reference to Fig. 5, the plurality of leads have thinned portions as the second portions having relatively low thickness, and the tie bars are thinned to have the low thickness. Etching the lead frame 700 may use a half-etching process which is readily available in the industry. The lead frame 700 is bent, or formed, such that the die flag 702 is displaced upwards with respect to the plurality of leads 704, as can be shown with reference to Fig. 5 and Fig. 6.

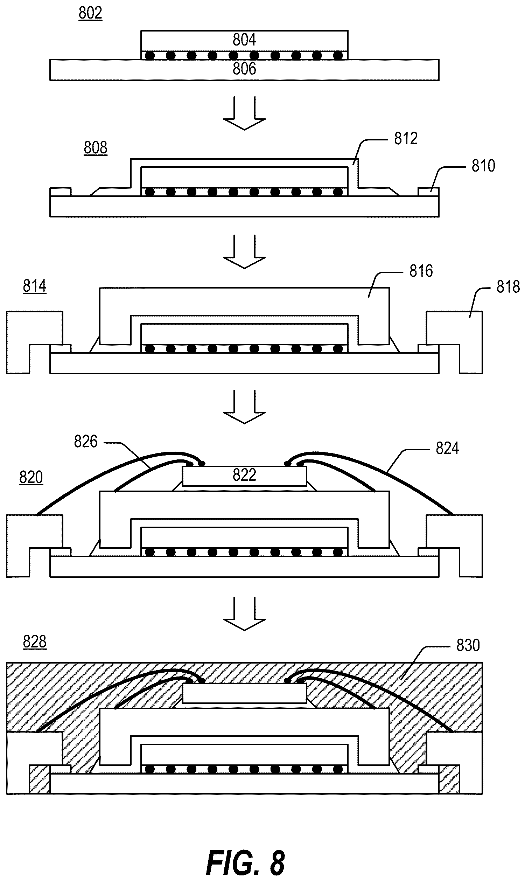

Fig. 8 shows cross-sectional views of assemblies during a flow of manufacturing a packaged device according to an embodiment. During a step 802, the first device die 804 is mounted to the substrate 806, with the lower surface of the first device die 804 (which surface typically includes active layers forming semiconductor components) facing the upper surface of the substrate 806. As described above, in an embodiment, the first device die 804 is mounted to the substrate 806 through the flip-chip technology. The resulting flip-chip unit is then processed in step 808 by disposing solder paste 810 onto the upper surface of the substrate 806 and Thermal Interface Material (TIM) 812 over the upper surface of the first device die 804. The solder paste 810 may be disposed onto the substrate 806 at positions of its peripheral sides through a screen printing process. The TIM 812 applied over the first device die 804, as described above, may be a thermal conductive material, which facilitates the heat generated by the first device die 804 to be dissipated to the die flag 816.

During a subsequent step 814, the lead frame is placed over the first device die 804 and the substrate 806, with the cover portion of the die flag 816 aligned with the first device die 804 and covering the first device die 804 while the flange portions of the die flag 816 extend around the first device die 804, and the second portions of the plurality of leads 818 aligned with and placed over the substrate 806, contacting the solder paste 810. Referring to Fig. 7, the lead frame may include multiple die flags arranged in an array. Accordingly, the assemblies from step 808 have been arranged in a corresponding array, for example loaded into a tray, before the lead frame is placed in step 814. The lead frame is placed over the first device die 804 and the substrate 806 such that the cover portion of the die flag 816 covers over the upper surface of the first device die 804, and the plurality of leads 818 surround, or are arranged around a periphery of, the substrate 806. The lower surfaces of the outer portions of the plurality of leads 818 are coplanar with and separated from the lower surface of the substrate 806. As described above, the first and second leads are arranged along peripheral sides of the lead frame, and the third lead is arranged at corners. Fig. 8 shows only the cross-sectional view of the second lead in the steps. The process may further include reflowing the assembly of step 814 to reliably connect the plurality of leads 818 with the substrate 806, both electrically and mechanically.

In step 820, the second die 822 is placed onto the upper surface of the cover portion of the die flag 816. The second die 822 may be attached to the die flag 816 through adhesive materials, for example an epoxy material. Step 820 also includes providing electrical connection between the second lead and the connection pads on the upper surface of the second die 822 through a bond wire 824. Optionally, if it is required to couple a ground voltage level or another type of signal into the second die 822, the step 820 may also include connecting the die flag 816 with corresponding connection pads arranged on the upper surface of the second die 822 through bond wires 826.

In step 828 of the process, molding compound 830 is applied to encapsulate the first device die 804, the second die 822, the substrate 806, and the lead frame. Molding compound 830 may be applied by injecting the molding materials into a molding cavity and curing the molding materials. After the step 828, the connector bars between neighboring lead frames, for example the connector bars 706 of Fig. 7, are removed in a singulation process by sawing or laser cutting along the connector bars, to singulate the packaged devices.

In the packaged devices of the embodiments, the lower surface of the substrate provides a BGA or LGA package format, and the plurality of leads provide a Quad-Flat No-lead (QFN) package format, having exposed ends on the lower parts of the side faces of the package, and exposed lower surfaces around the perimeter of the package. The packaged device provides both a high thermal performance and a high connection density.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A packaged device, comprising:
a substrate having a lower surface and an upper surface opposite the lower surface;
a die arranged on the upper surface of the substrate, the die having a lower surface facing the upper surface of the substrate, and an upper surface opposite the lower surface;
a die flag comprising a cover portion arranged over the upper surface of the die, wherein the cover portion has a lower surface and an upper surface opposite the lower surface; wherein the lower surface of the cover portion of the die flag faces the upper surface of the die; and
a plurality of leads arranged around a periphery of the substrate;
wherein the plurality of leads comprise a first lead connected to the die flag, and a second lead separated from the die flag;
wherein each of the plurality of leads comprises an outer portion which has a lower surface and an upper surface opposite the lower surface, the lower surfaces of the outer portions are coplanar with and separated from the lower surface of the substrate.

2. The packaged device of claim 1, wherein the first lead and the second lead extend to side faces of the packaged device, the first lead having a first width measured along the side face and the second lead having a second width measured along the side face; and wherein the first width is larger than the second width.

3. The packaged device of claim 1 or claim 2, further comprising a third lead arranged at a corner of the packaged device, wherein the third lead is connected to the die flag.

4. The packaged device according to any preceding claim, further comprising an additional die arranged on the upper surface of the die flag, the additional die having a lower surface facing the upper surface of the die flag, and an upper surface on which multiple connection pads of the additional die are arranged.

5. The packaged device of claim 4, wherein the second lead is electrically connected to a corresponding connection pad of the additional die.

6. The packaged device according to any preceding claim, wherein the outer portion of each of the plurality of leads has a first thickness measured from the lower surface to the upper surface of the outer portion, and wherein each of the plurality of leads further comprises an inner portion connected to the outer portion and extending from the outer portion towards the substrate, the inner portion of the lead having a second thickness which is less than the first thickness.

7. The packaged device of claim 6, wherein the inner portion of the lead is arranged to extend at least partly over the substrate.

8. The packaged device of claim 7, wherein the inner portion of the lead is mounted to the upper surface of the substrate through solder, and wherein the first thickness of the outer portion of the lead equals a sum of the second thickness of the inner portion of the lead and a thickness of the solder and a thickness of the substrate.

9. The packaged device of claim 6, wherein the inner portion of the first lead is connected to the die flag by way of a tie bar having the second thickness.

10. The packaged device of claim 6, wherein the cover portion of the die flag has the second thickness and is arranged central the die flag over the die, and wherein the die flag further comprises a flange portion connected to the cover portion and extending outwards from the cover portion, wherein the flange portion is arranged around the die and has the first thickness.

11. A method for manufacturing a packaged device comprising a substrate, a die, and a lead frame; wherein the method comprises:
mounting the die to the substrate, with a lower surface of the die facing an upper surface of the substrate;
arranging a die flag of the lead frame over an upper surface of the die;
arranging a plurality of leads of the lead frame to be around a periphery of the substrate, wherein each of the plurality of leads comprises an outer portion which has a lower surface and an upper surface opposite the lower surface, and wherein arranging the plurality of leads such that lower surfaces of the outer portions of the plurality of leads are coplanar with and separated from a lower surface of the substrate, wherein the plurality of leads comprise a first lead connected to the die flag, and a second lead separated from the die flag.

12. The method of claim 11, wherein arranging the plurality of leads of the lead frame to be around the periphery of the substrate comprises:
arranging the first lead and the second lead to extend to a side face of the packaged device; and
arranging a third lead of the plurality of leads at a corner of the packaged device; wherein the third lead is connected to the die flag.

13. The method of claim 11 or claim 12, further comprising:
mounting an additional die over an upper surface of the die flag; and
electrically connecting the second lead with a corresponding connection pad arranged on an upper surface of the additional die by way of a bond wire.

14. The method of any of claims 11 to 13, wherein the outer portion of each of the plurality of leads has a first thickness measured from the lower surface to the upper surface of the outer portion, and wherein each of the plurality of leads further comprises an inner portion connected to the outer portion and extending from the outer portion towards the substrate, the inner portion of the lead having a second thickness which is less than the first thickness, and wherein arranging the plurality of leads of the lead frame to be around a periphery of the substrate comprises:
arranging the outer portion of the lead as spaced apart from the substrate, such that a lower surface of the outer portion of the lead is coplanar with the lower surface of the substrate; and
mounting the inner portion of the lead onto the upper surface of the substrate.

15. A lead frame comprising:
a die flag comprising a cover portion having a lower surface and an upper surface opposite the lower surface;
a plurality of leads arranged around, and spaced apart from, the die flag, each of the plurality of leads comprising an outer portion having a lower surface and an upper surface opposite the lower surface, the plurality of leads comprising:
a first lead connected to the die flag and a connector bar; and
a second lead connected to the connector bar, and separated from the die flag.
